Europäisches Patentamt

European Patent Office

Office européen des brevets

(11) Publication number: **0 127 377**
**B1**

## EUROPEAN PATENT SPECIFICATION

(45) Date of publication of patent specification: **03.01.90**

(51) Int. Cl.⁵: **H 05 K 7/10**

(21) Application number: **84303285.5**

(22) Date of filing: **15.05.84**

(54) **Button board chip interconnection system.**

(30) Priority: **31.05.83 US 499137**

(43) Date of publication of application:
**05.12.84 Bulletin 84/49**

(45) Publication of the grant of the patent:
**03.01.90 Bulletin 90/01**

(84) Designated Contracting States:
**DE FR GB NL SE**

(56) References cited:
**WO-A-82/00386**
**DE-A-2 731 050**
**DE-B-2 912 202**
**FR-A-2 357 072**
**US-A-4 395 084**
**US-A-4 437 718**
**US-E-31 114**

(73) Proprietor: **TRW INC.**
**23555 Euclid Avenue**
**Cleveland Ohio 44117 (US)**

(72) Inventor: **Smolley, Robert**
**56 Limetree Lane**
**Porteuguese Bend California 90274 (US)**

(74) Representative: **Allden, Thomas Stanley et al**
**A.A. THORNTON & CO. Northumberland House**
**303-306 High Holborn**
**London WC1V 7LE (GB)**

Courier Press, Leamington Spa, England.

## Description

This invention relates to techniques for connecting an integrated circuit chip onto a printed circuit board.

Background of the Invention

Integrated circuit chips are typically mounted on a ceramic chip package which in turn is connected to a multi-layer printed circuit board. The multi-layer printed circuit board is typically plugged in at one edge to a larger printed circuit board, commonly called a "mother board". Each integrated circuit chip (hereinafter "chip") may be comprised of thousands of microscopic transistors which are ultimately connected to a plurality of conductive pads located along the periphery of the chip and providing electrical contact to the outside world. This contact is made by soldering extremely fine wires to the chip pads, the wires in turn being connected individually to pins located on the periphery of the ceramic chip package. The pins on the chip package in turn plug into matching receptacles located on the multi-layer printed circuit board.

One problem with the foregoing conventional method of connecting a chip to a large scale integrated system is that the bonding of the fine wire between the chip pads and the chip package pins requires expensive tooling and special labor which is typically done only in the factory. The wires themselves increase the interconnect inductance while the presence of the ceramic chip package increases the overall capacitance of the system, which inhibits operation at high speeds. Also, while a heatsink may be attached to the ceramic chip package, the chip package inhibits heat transfer between the chip and the heatsink, thus raising the operating temperature of the chip. Furthermore, the interconnection between each pad and the multi-layer printed circuit board requires four interconnections, namely the two ends of each wire soldered to the pad and the two ends of each pin on the chip package, which limits the quality of the overall connection. Finally, the required space in-between the chip package pins requires a chip package having an area much greater than the chip itself, on the order of three or four times. Therefore, the number of chips on a given multi-layer printed circuit board is necessarily limited.

In the present invention, reliable mounting and interconnection between a chip and a multi-layer printed circuit board is realised without a ceramic package, soldered wires, special tooling or special labor.

An arrangement is described in U.S.-E-31,114 in which a plurality of conductive connector elements are disposed between the contact pads of a semiconductor chip and contact areas of a printed circuit board and the thus formed assembly is compressed.

The present invention provides an electrical interconnect system for an integrated circuit chip, said integrated chip having a plurality of contact pads associated therewith, said system comprising:

a printed circuit board having a plurality of contact areas; a plurality of conductive connector elements and means for compressing the integrated circuit chip and printed circuit board so that the connector elements interconnect the contact areas with the contact pads said system being characterized as having:

an insulating button board positioned between the integrated circuit chip and the printed circuit board, said button board having a plurality of openings therethrough in registration with said plurality of contact pads of said integrated circuit chip, the plurality of conductive connector elements being disposed in the openings in the insulating button board, the contact areas of the printed circuit board being in registration with and facing said plurality of conductive connector elements, each of the connector elements comprising a strand of conductive wire formed into a compressible configuration, each of the connector elements having an uncompressed axial length such that it protrudes from both sides of the opening and having a face portion at opposite ends thereof, said wire making electrical contact at multiple points with said contact areas and said pads when compressed against said contact areas and said pads.

Each cylindrical button board opening holds a fuzz button or wrapped wire connector element comprising a cylinder of finely compressed wrapped wire. The connector elements or "fuzz buttons" are each formed as a single strand of wadded wire that makes electrical contact at multiple points when compressed against a contact area. Connectors of this type have significant advantages over soldered or wire-wrapped connections, and provide connections of high integrity and reliability. In contrast to a soldered connection, this mechanical connector element has very few associated variables that can effect the quality of the connection. In fact the only significant variables are the size of the element, which can be fairly accurately controlled, and the compressive force used to make the connection, which is also easily controllable. The cylindrical fuzz button is greater in length than the thickness of the button board so that it protrudes beyond both the top and bottom faces of the button board and makes contact with the underlying chip pad.

Overlying the button board and its plurality of fuzz buttons is the multi-layer printed circuit board which has specially patterned conductive elements on its bottom surface facing the button board, individual ones of these contact areas being in registration with individual ones of the fuzz buttons held in the button board openings. Accordingly, the multi-layer printed circuit board is electrically interconnected with each of the chip pads through the fuzz buttons. Excellent ohmic contact is assured by means of a clamp overlying the multi-layer printed circuit board. The clamp is fastened to the underlying housing so that each of the fuzz buttons is compressed between the underlying pad and the overlying printed circuit board contact area. The compression causes the fuzz buttons to deform so as to accommodate the compression and form a very high quality electrical connection. Preferably, the deformation of the buttons is elastic so that, upon release, the buttons return to their original shape.

The advantages of the invention include the elimination of the ceramic package and its attendant soldered wires. As a result, no special tooling or labor is required to connect the chip to the printed circuit board, and in fact the chip can be replaced outside of the factory by a user with very simple tools and no special labor. Furthermore, the interconnect inductance of the soldered wires and the dielectric capacitance of the ceramic chip package are eliminated. There is only one interconnection between each chip pad and the multilayer printed circuit board, namely the corresponding fuzz button which results in a much higher quality electrical connection. Elimination of the ceramic chip package eliminates the main source of resistance to heat transfer between the chip package and the heatsink comprising the housing. Finally, there is no interconnection fanout between the chip pads and the ultimate connection to the multi-layer printed circuit board, so that the density of chips mounted on a multi-layer printed circuit board in this invention is three or more times greater than that of the prior art. Probably the most significant advantage of the invention is the savings in cost due to the elimination of special tooling and special labor connected with soldering the individual wires between the chip pads and the ceramic package pins of the prior art.

It is expected that the invention will find use for connecting integrated circuits in computers, toys, military electronics and consumer electronics.

Description of the Drawings

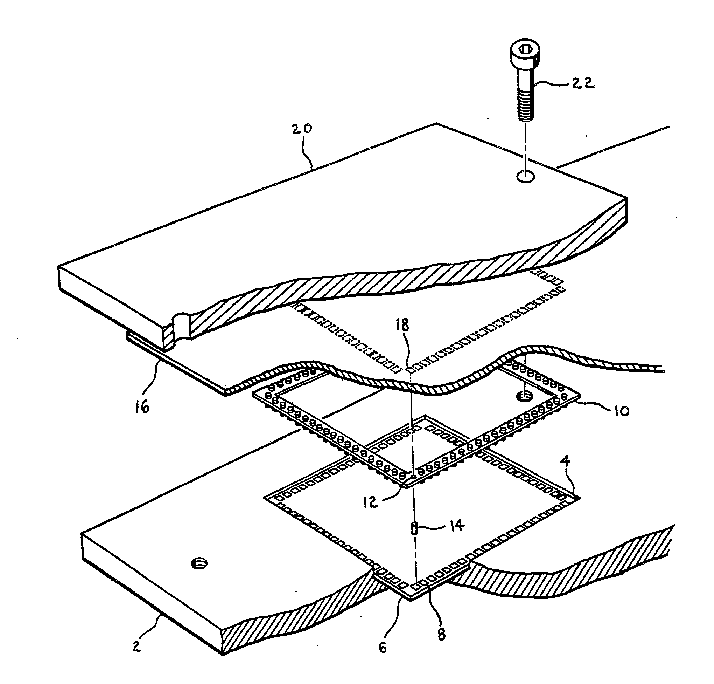

The invention is best understood by reference to the accompanying drawing, Figure 1, which is an exploded perspective view illustrating the button board chip interconnection system of this invention.

Detailed Description of the Invention

Referring to Figure 1, a housing (2) may serve as both a hermetic seal and a heatsink. The housing (2) may comprise, for example, a planar aluminum substrate of approximately .055 inches in thickness and includes a recess (4) formed in the top surface thereof of about .035 inch in depth in the example of Figure 1. An integrated circuit chip (6) fits snugly in the recess (4), the chip being on the order of .025 inches in thickness in this example. The top surface of the chip (6), which includes the thin film integrated circuits and a plurality of peripheral contact pads (8), faces away from the housing (2). A button board (10) also fits snugly in the recess (4) over the top surface of the chip (6) and has a thickness on the order of .010 inches in this example. Preferably, the recess (4), the chip (6) and the button board (10) are virtually congruent to assure a tight fit. The bottom board (10) includes a plurality of openings (12), each of which can hold a single fuzz button (14) or wrapped wire connector element protruding from both ends of each opening (12).

The fuzz button (14) comprises very fine wire which is wrapped into a solid form. Preferably each of the openings (12) comprises a circular aperture of about .004 inch in diameter extending through the thickness of the button board (10) in registration with individual ones of the peripheral contact pads (8), and each fuzz button (14) comprises beryllium-copper alloy wire of about .0003 to .0005 inch in diameter wrapped in a cylindrical shape of about .004 inch in diameter (so that it fits snugly in an opening (12)) and approximately .016 inches high.

The fuzz button (14) may be formed of alternative materials such as a copper-silver alloy comprising 98.5% copper and 1.5% silver or may comprise a phosphor-bronze alloy wire. The wire is pressed into a solid shape (such as the preferred cylinder) to form a fuzz button of about 30% volume density.

A circuit board (16), preferably comprising a multi-layer printed circuit board, overlies the housing (2), the chip (6) and the button board (10), and is pressed toward the housing (2) by means of a clamp (20) and a bolt (22). The printed circuit board (16) includes a plurality of individual conductive contact areas (18) on the bottom surface thereof, which are in registration with individual ones of the fuzz buttons. The fuzz buttons (14) are compressed by the clamp (20) from their original .016 inch length to about the .010 inch thickness of the button board (10) between the chip pads (8) and the individual conductive contact areas (18). In this manner, a high quality electrical connection is formed by each fuzz button (14) between the corresponding chip pad (8), in contact with one end of the fuzz button, and the corresponding circuit board contact area (18), in contact with the other end of the fuzz button (14). Preferably, the compression of the fuzz buttons (14) is completely elastic so that, when the compressive force of the clamp (20) is removed, the fuzz buttons (14) return to their original shape. The chip (6) may be removed and replaced while the fuzz buttons (14) and the button board (10) may be reinstalled and used again.

Typically, the chip contact pads (8) comprise square areas of thin film metallization on the chip periphery, each pad being .004 inch on a side located at .005 inch centers along the chip periphery. The foregoing detailed description is exemplary in nature and describes what is the preferred mode of the invention. However, other variations are possible. For example, the fuzz buttons may be square in cross-section rather than circular so that the openings (12) would also be square. Furthermore, the dimensions given are exemplary and other dimensions, such as the thickness of the housing (2), the depth of the recess (4), the thickness of the chip (6) and the thickness of the button board (10) may differ from the foregoing example without departing from the scope of the invention. Finally, it is not necessary that the housing (2) be of aluminum metal or that it be a heatsink. For example, only a portion of the housing (2) which is in contact with the chip may be a heatsink element, the rest of the housing (2) being thermally passive. Furthermore, arrangements other than the recess (4) and the clamp (20) may be provided for registering the fuzz buttons (14) with the contact pads (8).

The button board (10) may be formed of a rigid plastic material such as epoxy. The only requirement of the multi-layer printed circuit board is that it have the circuit board contact areas (18) on its bottom surface in registration with the fuzz buttons (14), the button board openings (12) and the chip contact pads (8). Furthermore, the board (16) does not necessarily have to be a multi-layer printed circuit board.

In case of chip malfunction, it is contemplated that the system comprising the printed circuit board (16) may be repaired by simply replacing individual chips (6) that are connected to it. The operation is simple and merely requires releasing the clamp bolt (22), removing the clamp (20), the printed circuit board (16), the button board (10) (1eaving the plurality of fuzz buttons in their respective button board openings (12)) and removing and replacing the chip (6) and reversing the foregoing procedure.

## Claims

1. An electrical interconnect system for an integrated circuit chip (6), said integrated chip having a plurality of contact pads (8) associated therewith, said system comprising:
a printed circuit board having a plurality of contact areas (18); a plurality of conductive connector elements and means (21, 22) for compressing the integrated circuit chip (6) and printed circuit board (16) so that the connector elements (14) interconnect the contact areas with the contact pads (8) said system being characterized as having:
an insulating button board (10) positioned between the integrated circuit chip (6) and the printed circuit board, said button board having a plurality of openings (12) therethrough in registration with said plurality of contact pads of said integrated circuit chip, the plurality of conductive connector elements (14) being disposed in the openings (12) in the insulating button board (10), the contact areas of the printed circuit board being in registration with and facing said plurality of conductive connector elements, each of the connector elements comprising a strand of conductive wire formed into a compressible configuration, each of the connector elements having an uncompressed axial length such that it protrudes from both sides of the opening and having a face portion at opposite ends thereof, said wire making electrical contact at multiple points with said contact areas and said pads when compressed against said contact areas and said pads.

2. An electrical interconnect system according to claim 1, and comprising a housing (2) equipped with means for disposing said chip in connecting relationship with said insulating button board (10).

3. The electrical interconnect system according to claim 2, wherein said housing includes a heat sink disposed in heat transfer relation to said chip.

4. An electrical interconnect system according to any preceding claim wherein the wire of each connector element is on the order of 7,62 μm (.0003) to 12,7μm (.0005 inches) in diameter and of one of the following alloys: beryllium copper, silver copper, or phosphorous bronze.

5. An electrical interconnect system according to claim 4, wherein each formed strand of wire is pressed into a solid shape of about 30% volume density.

6. An electrical interconnect system according to claim 5, wherein the shape of the formed strand of wire is cylindrical.

7. A device for interconnecting an integrated circuit chip (6) and a printed circuit board (16) comprising;
an insulating button board (10) positioned between the integrated circuit chip (6) and the printed circuit board, said button board having a plurality of openings (12) therethrough in registration with pad (8) of said integrated circuit chip (6), a plurality of conductive connector elements (14) disposed in the openings (12) in the insulating board (10) each of the connector elements comprising a strand of conductive wire formed into a compressible configuration and having an uncompressed axial length such that it protrudes from both sides of the openings and having face portions at opposite ends thereof, said wire making electrical contact at multiple points with contact areas of the printed circuit board and with the pads when compressed against said contact areas and said pads.

8. An electrical interconnect according to claim 7, wherein the wire is of the order of 7,62 μm to 12,7 μm (.0003 to .0005 inches) in diameter and of one of the following alloys: beryllium copper, silver copper, or phosphorous bronze.

9. An electrical interconnect according to claim 7, wherein each formed strand of wire is pressed into a solid shape of about 30% volume density.

## Patentansprüche

1. Ein elektrisches Verbindungssystem für ein integriertes Schaltungs-Chip (6), wobei das genannte integrierte Chip eine Vielzahl von Kontaktflecken (8) aufweist, die mit ihm verbunden sind, wobei das System folgende Bauteile aufweist:
eine gedruckte Schaltungsplatine mit einer Vielzahl von Kontaktflächen (18); eine Vielzahl von leitenden Verbindungselementen und eine Einrichtung (21, 22) zum Zusammendrücken des integrierten Schaltungs-Chips (6) und der gedruckten Schaltungsplatine (16), so daß die Verbindungselemente (14) die Kontaktflächen mit den Kontaktflecken (8) verbinden, dadurch geknnzeichnet, daß das System folgendes aufweist:

eine isolierende Knopf-Tafel (10), die zwischen dem integrierten Schaltungs-Chip (6) und der gedruckten Schaltungs-Platine angeordnet ist und eine Vielzahl von Öffnungen (12) aufweist, zu denen die Vielzahl von Kontaktflecken des genannten integrierten Schaltungs-Chips ausgerichtet sind, wobei die Vielzahl von leitenden Verbindungselementen (14) in den Öffnungen (12) in der isolierenden Knopf-Tafel (10) angeordnet sind, die Kontaktflächen der gedruckten Schaltungs-Platine gegenüberliegend auf die Vielzahl von leitenden Verbindungselementen ausgerichtet sind, von denen jedes eine Ader eines Leitungsdrahtes aufweist, der in einer kompressiblen Anordnung ausgebildet ist, wobei jedes der Verbindungselemente eine nicht zusammengedrückte axiale Länge aufweist, so daß es von beiden Seiten der Öffnung vorsteht und an gegenüberliegenden Enden Stirnabschnitte aufweist, und wobei der genannte Draht einen elektrischen Kontakt an einer Vielzahl von Punkten mit den genannten Kontaktflächen herstellt sowie den Kontaktflecken, wenn er gegen die genannten Kontaktflächen und Kontaktflecken gedrückt ist.

2. Ein elektrisches Verbindungssystem gemäß Anspruch 1 mit einem Gehäuse (2), das mit Einrichtungen versehen ist zum Anordnen des genannten Chips in einem Verbund-Zustand mit der genannten isolierenden Knopf-Tafel (10).

3. Ein elektrisches Verbindungssystem gemäß Anspruch 2, wobei das genannte Gehäuse eine Wärme-Senke aufweist, die in wärmeleitender Verbindung mit dem genannten Chip steht.

4. Ein elektrisches Verbindungssystem gemäß einem der vorhergehenden Ansprüche, wobei der Draht eines jeden Verbindungselementes einen Durchmesser in der Größenordnung von 7,62 µm (.0003) bis 12,7 µm (.0005 Zoll) aufweist und aus einer der folgenden Legierungen besteht: Beryllium/Kupfer, Silber/Kupfer oder Phosphor/Bronze.

5. Ein elektrisches Verbindungssystem gemäß Anspruch 4, wobei jede geformte Draht-Ader in eine feste Form gepreßt ist mit einer Volumendichte von etwa 30%.

6. Ein elektrisches Verbindungssystem gemäß Anspruch 5, wobei die Form der geformten Draht-Ader zylindrisch ist.

7. Eine Einrichtung zum Verbinden eines integrierten Schaltungs-Chips (6) mit einer gedruckten Schaltungsplatine (16) mit folgenden Bauteilen:

einer isolierenden Knopf-Tafel (10), die zwischen dem integrierten Schaltungs-Chip (6) und der gedruckten Schaltungsplatine angeordnet ist und eine Vielzahl von durchgehenden Öffnungen (12) aufweist, die in bezug auf Kontaktflecken (8) des genannten integrierten Schaltungs-Chip (6) ausgerichtet sind, einer Vielzahl von leitenden Verbindungselementen (14), die in den Öffnungen (12) in der isolierenden Tafel (10) angeordnet sind und von denen jedes eine Litze aus leitendem Draht aufweist, die in einer kompressiblen Weise ausgeformt ist und eine nicht zusammengedrückte axiale Länge aufweist, so daß sie aus beiden Seiten der Öffnungen vorsteht und an gegenüberliegenden Enden derselben Stirnabschnitte aufweist, wobei der genannte Draht elektrischen Kontakt an vielen Stellen mit Kontaktflächen der gedruckten Schaltungsplatine herstellt sowie mit den Kontaktflecken, wenn er gegen die genannten Kontaktflächen und die genannten Kontaktflecken gedrückt wird.

8. Ein elektrisches Verbindungssystem gemäß Anspruch 7, wobei der Draht einen Durchmesser in der Größenordnung von 7,62 µm bis 12,7 µm (.0003 bis .0005 Zoll) aufweist und aus einer der folgenden Legierungen besteht: Beryllium/Kupfer, Silber/Kupfer oder Phoshpor/Bronze.

9. Eine elektrische Verbindung gemäß Anspruch 7, wobei jede geformte Draht-Litze in eine feste Form gepreßt ist, die eine Volumendichte von etwa 30% aufweist.

**Revendications**

1. Un système d'interconnexion électrique pour une puce de circuit intégré (6), à laquelle est associé un ensemble de plots de contact (8), ce système comprenant:

une carte de circuit imprimé comportant un ensemble de zones de contact (18); un ensemble d'éléments de connecteur conducteurs et des moyens (21, 22) pour comprimer la puce de circuit intégré (6) et la carte de circuit imprimé (16), de façon que les éléments de connecteur (14) interconnectent les zones de contact et les plots de contact (8), ce système étant caractérisé en ce qu'il comporte:

une carte à boutons isolante (10) placée entre la puce de circuit intégré (6) et la carte de circuit imprimé, cette carte à boutons étant traversée par un ensemble d'ouvertures (12) en coïncidence avec l'ensemble de plots de contact de la puce de circuit intégré, l'ensemble d'éléments de connecteur conducteurs (14) étant placés dans les ouvertures (12) dans la carte à boutons isolante (10), les zones de contact de la carte de circuit imprimé étant en coïncidence avec l'ensemble d'éléments de connecteur conducteurs, et faisant face à ces derniers, chacun des éléments de connecteur comprenant un brin de fil conducteur auquel on a donné une configuration compressible, chacun des éléments de connecteur ayant une longueur axiale à l'état non comprimé telle qu'il dépasse des deux côtés de l'ouverture, et présentant une face à ses extrémités opposées, ce fil établissant un contact électrique en de multiples points avec les zones de contact et les plots, lorsqu'il est comprimé contre les zones de contact et les plots.

2. Un système d'interconnexion électrique selon la revendication 1, comprenant un boîtier (2) qui est équipé de moyens pour placer la puce dans une relation de connexion avec la carte à boutons isolante (10).

3. Le système d'interconnexion électrique selon la revendication 2, dans lequel le boîtier comprend un radiateur qui est placé en relation de transfert de chaleur avec la puce.

4. Un système d'interconnexion électrique selon l'une quelconque des revendications précédentes, dans lequel le fil de chaque élément de connecteur mesure de l'ordre de 7,62 µm à 12,7 µm de diamètre, et il est constitué par l'un des alliages suivants: cuivre-beryllium, cuivre-argent ou bronze phosphoreux.

5. Un système d'interconnexion électrique selon la revendication 4, dans lequel chaque brin de fil qui a été mis en forme est comprimé de façon à obtenir une forme pleine ayant une densité d'environ 30% de celle du matériau constitutif.

6. Un système d'interconnexion électrique selon la revendication 5, dans lequel chaque brin de fil qui a été mis en forme présente une forme cylindrique.

7. Un dispositif pour interconnecter une puce de circuit intégré (6) et une carte de circuit imprimé (16), comprenant:

une carte à boutons isolante (10) qui est placée entre la puce de circuit intégré (6) et la carte de circuit imprimé, cette carte à boutons étant traversée par un ensemble d'ouvertures (12) en coïncidence avec des plots (8) de la puce de circuit intégré (6), et un ensemble d'éléments de connecteur conducteurs (14) placés dans les ouvertures (12) dans la carte isolante (10), chacun des éléments de connecteur comprenant un brin de fil conducteur auquel on a donné une configuration compressible, et ayant une longueur axiale à l'état non comprimé telle qu'il dépasse des deux côtés des ouvertures, et présentant des faces à ses extrémités opposées, ce fil établissant un contact électrique en de multiples points avec des zones de contact de la carte de circuit imprimé et avec les plots, lorsqu'il est comprimé contre les zones de contact et les plots.

8. Une interconnexion électrique selon la revendication 7, dans laquelle le fil a un diamètre de l'ordre de 7,62 µm à 12,7 µm, et il est constitué par l'un des alliages suivants: cuivre-beryllium, cuivre-argent ou bronze phosphoreux.

9. Une interconnexion électrique selon la revendication 7, dans laquelle chaque brin de fil qui a été mis en forme est comprimé pour donner une forme pleine ayant une densité d'environ 30% de celle du matériau constitutif.